# EUROPEAN PATENT SPECIFICATION

(11) **EP 1 398 963 B1**
(45) Date of publication and mention of the grant of the patent: **26.03.2008**
(21) Application number: 03018320.6
(22) Date of filing: 12.08.2003
(51) Int. Cl.: H04N 5/50

(54) **Broadcast receiving apparatus and broadcast receiving method**
Verfahren und Vorrichtung zum Empfangen einer Rundfunkübertragung
Procédé et dispositif de réception d'émissions télédiffusées

(30) Priority: 11.09.2002 JP 2002265681
(43) Date of publication of application: 17.03.2004
(73) Proprietor: KABUSHIKI KAISHA TOSHIBA, Tokyo (JP)
(72) Inventor: Yamashita, Keita c/o Toshiba Corporation, 1-1 Shibaura 1-chome Minato-ku Tokyo 105 (JP)
(74) Representative: Henkel, Feiler & Hänzel

(56) References cited:
- DE-A- 10 027 457
- FR-A- 2 649 571
- US-A- 5 684 541
- US-A- 6 034 743
- PATENT ABSTRACTS OF JAPAN vol. 0182, no. 05 (E-1536), 12 April 1994 (1994-04-12) & JP 6 006693 A (TOSHIBA CORP; others: 01), 14 January 1994 (1994-01-14)

## Description

The present invention relates to a broadcast receiving apparatus and a broadcast receiving method for receiving, for example, a television broadcast, and in particular, to improvements in a function for automatically searching for and presetting a large number of broadcast channels.

As is well known, current television broadcast receivers comprise, as a function for presetting broadcast channels, an "auto channel preset function" for automatically searching for and presetting a large number of broadcast channels.

The auto channel preset function sequentially varies a reception frequency step by step at predetermined increments from a lower frequency to a higher frequency and carries out detection as to whether or not a television signal can be correctly received at each reception frequency.

Then, the reception frequencies at which television signals can be correctly received are sequentially registered in a nonvolatile memory in association with, for example, channel numbers for corresponding broadcast stations.

In television broadcasting, a broadcast mode, i.e. a frequency band, a standard mode, a modulation mode, and the like for broadcasting television signals vary significantly among countries or areas.

For example, European areas employ a mode of executing a negative modulation process on television signals (a B/G, I, or D/K system) and a mode of executing a positive modulation process on television signals (an L system).

In connection with one of these modes, the current auto channel preset function varies the reception frequency step by step at predetermined increments to search for broadcast channels through which television signals can be correctly received, and registers these broadcast channels in a memory.

Subsequently, in connection with another mode, the current auto channel preset function varies the reception frequency step by step at predetermined increments to search for broadcast channels through which television signals can be correctly received, and registers these broadcast channels in the memory.

However, the current auto channel preset function repeatedly performs the same search operation on each of the negative and positive modulation modes.

That is, the time required from the start to end of the auto channel preset is simply double the time required for the auto channel preset for one of the modulation modes. It has thus been desirable to reduce this time.

According to Jpn. Pat. Appln. KOKAI Publication No. 6-6693, for channel preset, signalling channels are first searched for on the basis of frequency data of a predetermined step width.

Then, if a signaling channel has been successfully found, the next search is carried out using the above frequency data as a reference and using a step width set on the basis of a channel spacing frequency. This reduces a channel search time.

However, the configuration shown in this publication requires the television broadcast receiver to store channel spacing frequencies for respective countries or areas beforehand. Thus, every time the number of countries or areas to which television broadcast receivers are shipped increases or the broadcast mode is changed, the stored contents must be updated.

US 6 034 743 discloses a broadcast receiving apparatus. According to this state of the art there is provided an automatic tuning apparatus capable of automatically switching the tuning mode of a tuner circuit, automatically arranging various signal data in or after completion of tuning and arbitrarily and automatically arranging various signal data by the user comprises a SYNC discrimination circuit discriminating whether a video signal system is the NTSC system or another system, a tuning mode switching circuit for switching the tuning mode, and a color discrimination circuit receiving a color bust signal (identic signal) for discriminating whether the video signal system is the PAL system or the SECAM system. As to the NTSC system, the PAL system, the SECAM system and the SECAM-L system, the user may not set the tuning mode of tuning circuit, whereby an automatic tuning apparatus imposing no burden on the user can be obtained.

It is an object of the present invention to provide a broadcast receiving apparatus and a broadcast receiving method which reduce the time required to search for broadcast channels when automatically searching for and presetting broadcast channels in connection with, for example, the negative or positive modulation broadcast mode.

The above object is achieved by a method for automatically searching for and presetting of broadcast reception channels according to claim 1, a broadcast receiving apparatus according to claim 2 and by a computer program according to claim 3.

The invention can be more fully understood from the following detailed description when taken in conjunction with the accompanying drawings, in which:
FIG. 1 is a view showing a television broadcast receiver according to an embodiment of the present invention;
FIG. 2 is a block diagram showing the details of a signal processing system of the television broadcast receiver according to the embodiment;
FIG. 3 is flow chart showing an auto channel preset operation preformed by the television broadcast receiver according to a first example, which is not covered by the claims;
FIG. 4 is flow chart showing an auto channel preset operation preformed by the television broadcast receiver according to the above example;
FIG. 5 is flow chart showing an example of an auto channel preset operation performed by the television broadcast receiver according to an embodiment; of the invention.
FIG. 6 is flow chart showing an example of an auto channel preset operation performed by the television broadcast receiver according to the embodiment;
FIG. 7 is a view showing a DVD recording and reproduction apparatus according to another embodiment of the present invention;
FIG. 8 is a block diagram showing a signal processing system of the DVD recording and reproduction apparatus according to the embodiment.

Embodiments of the present invention will be described below in detail with reference to the drawings.

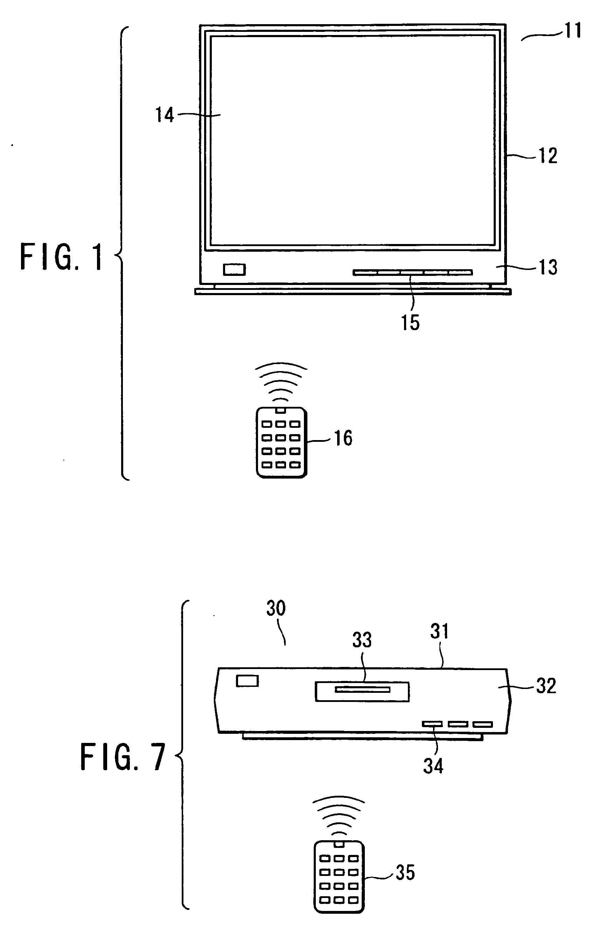

FIG. 1 is a view showing a television broadcast receiver 11 according to an embodiment of the present invention.

The television broadcast receiver 11 comprises a housing 12 formed generally like a box and having a front surface portion 13 on which a picture display screen 14 and an operation section 15 composed of a power switch and various keys are arranged.

Further, the television broadcast receiver 11 receives operation information not only from the operation section 15 but also from a wireless remote controller 16 to control its own operations.

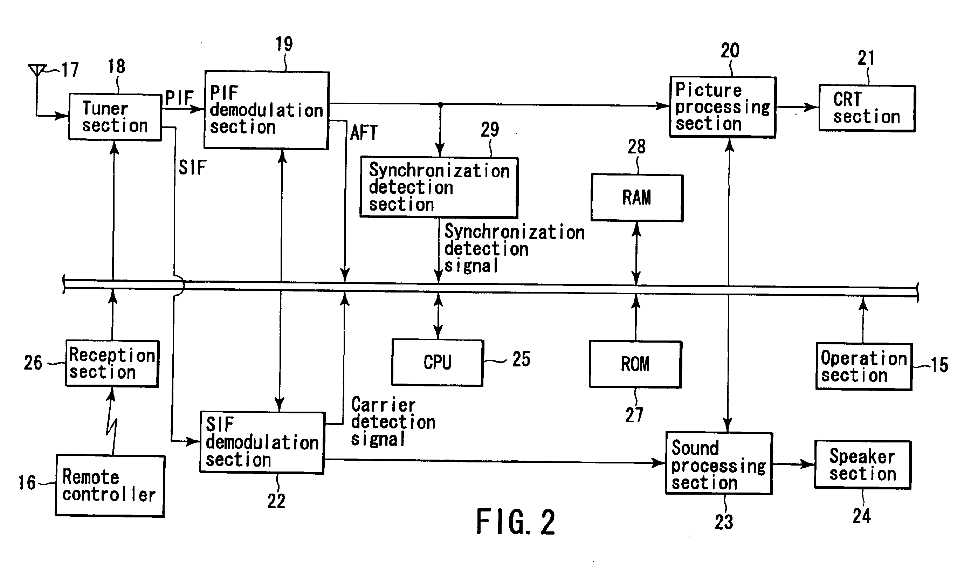

FIG. 2 is a block diagram showing the details of a signal processing system of the television broadcast receiver 11 according to this embodiment.

First, in FIG. 2, reference numeral 17 denotes an antenna that receives television broadcast electric waves.

A television signal received by the antenna 17 is supplied to a tuner section 18 based on a PLL (Phase Locked Loop) frequency synthesizing method.

In this case, the tuner section 18 mixes a received television signal with a local oscillation signal to generate a PIF (Picture Intermediate Frequency) signal and an SIF (Sound Intermediate Frequency) signal.

A PIF demodulation section 19 demodulates the PIF signal into a base band picture signal. Then, a picture processing section 20 executes signal processing on the base band picture signal for picture display. Subsequently, a CRT (Cathode Ray Tube) section 21 displays a picture on the picture display screen 14.

Further, an SIF demodulation section 22 is supplied with the SIF signal and demodulates it into a sound signal. A sound processing section 23 then processes the signal for sound reproduction. Subsequently, a speaker section 24 reproduces sound.

A CPU (Central Processing Unit) 25 controls the series of reproduction operations for television signals in a unified manner. The CPU obtains operation information from the operation section 15 or from the remote controller 16 via a reception section 26 to control the sections 18 to 20, 22, and 23 so as to establish an operational state desired by a user.

In this case, the CPU 25 controls the sections 18 to 20, 22, and 23 on the basis of control programs stored in a ROM (Read Only Memory) 27 and various set values or the like recorded in a non-volatile RAM (Random Access Memory) 28, using the RAM 28 as a work area.

Here, on the basis of the inputted PIF signal, the PIF demodulation section 19 generates an AFT (Automatic Fine Tuning) signal utilized to automatically search for broadcast channels and outputs this signal to the CPU 25. This AFT signal is available whether a picture signal is based on positive or negative modulation.

Further, a synchronization detection section 29 is supplied with a base band picture signal outputted by the PIF demodulation section, to detect a synchronization signal. A synchronization detection signal outputted by the synchronization detection section 29 is outputted to the CPU 25.

Furthermore, the SIF demodulation section 22 detects a sound carrier in the inputted SIF signal. The sound carrier has a frequency of 5.5 MHz for the B/G system, 6.0 MHz for the I system, and 6.5 MHz for the D/K and L systems. A carrier detection signal outputted by the SIF demodulation section 22 is outputted to the CPU 25.

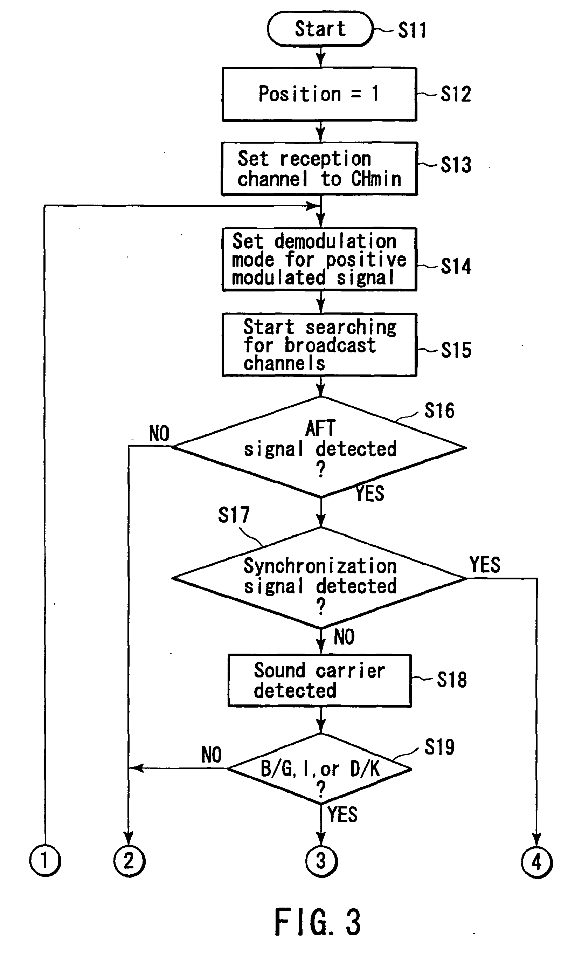

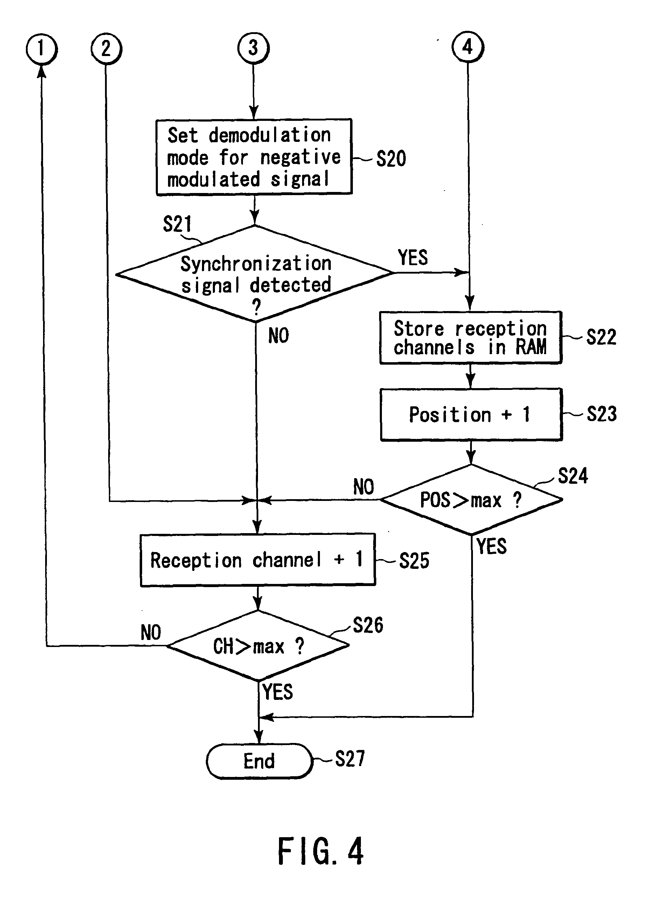

FIGS. 3 and 4 are flow charts showing an auto channel preset operation preformed by the television broadcast receiver 11 according to an illustrative example, which is not part of the invention.

First, in step S11, a request is issued for the start of an auto channel preset operation. In step S12, the CPU 25 sets the position POS of an area in the RAM 28 in which preset data is stored, to 1.

Further, in step S13, the CPU 25 sets a reception channel CH at the lowest frequency CHmin, and in step S14, sets the PIF demodulation section 19 in a mode in which television signals subjected to positive modulation are demodulated.

Subsequently, in step S15, the CPU 25 starts searching for broadcast channels at the currently set reception channel CH, and in step S16, determines whether or not the AFT signal is detected.

In this case, if the AFT signal is not detected (NO), the CPU 25 determines that no television signals are present on the current reception channel CH. In step S25, the CPU 25 adds 1 to the current reception channel CH to shift to a reception frequency higher than the current one by a specified frequency.

In step S26, the CPU 25 determines whether or not the reception channel CH has exceeded its maximum value max. If it has not exceeded the maximum value max (NO), the CPU 25 returns to step S14. If it has exceeded the maximum value max (YES), the CPU 25 ends the process (step S27).

Further, if the AFT is detected (YES) in step S16, the CPU 25 determines that there is a television signal on the current reception channel CH. In step S17, the CPU 25 determines whether or not the synchronization detection signal is detected.

If the synchronization detection signal is not detected (NO), a different television signal modulation mode may be used. In step S18, the CPU 25 detects a carrier detection signal, and in step S19, determines whether or not a sound carrier for the B/G, I, or D/K system is detected.

If the sound carrier for the B/G, I, or D/K system is not detected (NO), the CPU 25 determines that there are no television signals on the current reception channel CH. The CPU 25 then shifts to step S25.

On the other hand, if the sound carrier for the B/G, I, or D/K system is detected (YES) in step S19, the CPU 25 determines that the television signal is based on a negative modulation mode. In step S20, the CPU 25 sets the PIF demodulation section 19 in a mode in which television signals subjected a to negative modulation process by the PIF demodulation section 19 is demodulated.

Then, in step S21, the CPU 25 determines whether or not the synchronization detection signal is detected. If the synchronization detection signal is not detected (NO), the CPU 25 determines that there are no television signals on the current reception channel CH. The CPU 25 then shifts to step S25.

On the other hand, if the synchronization detection signal is detected in step S17 or S21, the CPU 25 determines that the television signal subjected to a negative modulation process has been successfully reproduced. In step S22, the CPU 25 stores the current reception channel CH at the currently set position POS of the RAM 28 in association with the corresponding broadcast channel.

Subsequently, in step S23, the CPU 25 adds 1 to the current position POS. In step S24, the CPU 25 determines whether or not the position POS has exceeded its maximum value max. If it has not exceeded the maximum value max (NO), the CPU 25 shifts to step S25. If it has exceeded the maximum value max (YES), the CPU 25 ends the process (step S27).

According to the above example, in the mode in which television signals subjected to a positive modulation process are demodulated, if the AFT signal is detected but the synchronization signal is not, the sound carrier corresponding to a television signal based on the negative modulation mode is detected to determine whether or not there are any television signals based on the negative modulation mode.

Then, if it is determined that there is a television signal based on the negative modulation mode, the PIF demodulation section 19 is switched to the mode in which television signals subjected to a negative modulation process are demodulated. If the synchronization signal is detected in this mode, that reception channel CH is preset.

That is, in the demodulation mode corresponding to the positive modulation mode, if it is determined that the synchronization signal is not obtained for a reception channel CH on which the AFT signal is detected, the demodulation mode is immediately switched to the one corresponding to the negative modulation mode to detect the synchronization signal.

Thus, the AFT signal detection operation performed in the demodulation mode corresponding to the positive modulation mode is not wasted. This reduces the time required to search for broadcast channels.

In the prior art, in the demodulation mode corresponding to the positive modulation mode, if the AFT signal is detected but the synchronization signal is not, that reception channel is not registered. Then, when broadcast channels are searched for in the demodulation mode corresponding to the negative modulation mode, an attempt is made again to detect the AFT signal on the same reception channel. That is, in the prior art, the AFT signal detection operation is performed twice on the same reception channel. This increase the time required to search for broadcast channels.

Further, in the above example, even if a broadcast channel detection operation is started in the demodulation mode corresponding to the positive modulation mode and the demodulation mode is then switched to the one corresponding to the negative modulation mode during this operation, then for the next reception channel, the broadcast channel detection operation is started again in the demodulation mode corresponding to the positive modulation mode.

Thus, this example is effective in reducing the time required for auto channel preset, for example, in an area in which there are more broadcast channels corresponding to the positive modulation mode than those corresponding to the negative modulation mode.

In contrast, the following is also possible: even if the search for broadcast channels is started in the mode in which television signals subjected to a negative modulation process are demodulated and the mode is then switched, during this operation, to the one in which television signals subjected to a positive modulation process are demodulated, then for the next reception channel, the broadcast channel detection operation is started again in the demodulation mode corresponding to the negative modulation mode.

Furthermore, it is contemplated that at least either the operation section 15 or the remote controller 16 is provided with a switch used to allow the user to make selection as to which demodulation mode is used first to search for broadcast channels.

This allows the user to start searching for broadcast channels by selecting the demodulation mode corresponding to a modulation mode involving more broadcast channels depending on the country or area in which the user is present. This further reduces the time required to search for broadcast channels.

In this case, the switch used to select the demodulation mode may be adapted to allow the user to select the country or area or the modulation mode.

Further, the auto channel preset may be automatically started in response to turn-on of the power switch of the television broadcast receiver 11 or may be started by the user by operating a particular key installed on at least one of the operation section 15 and the remote controller 16.

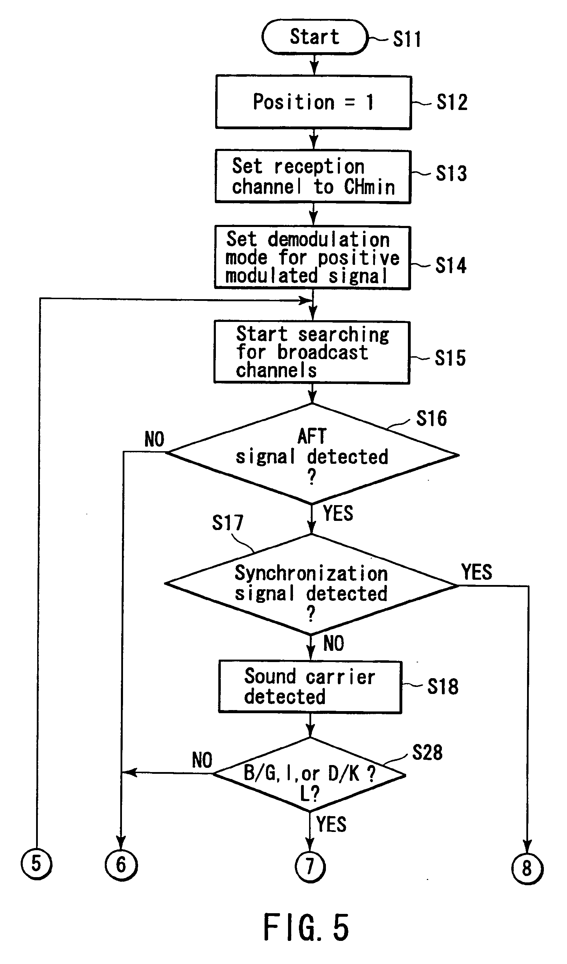

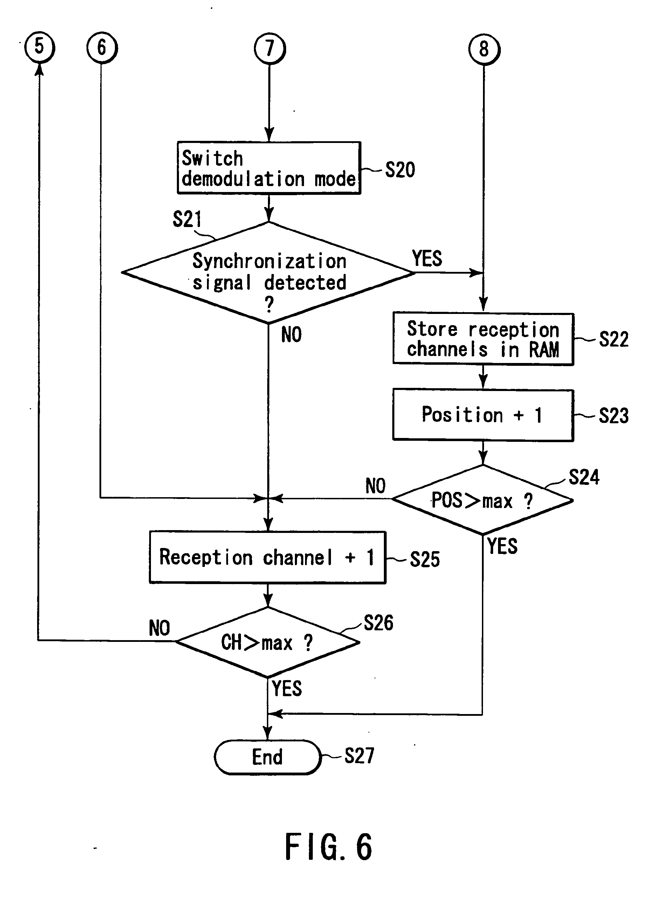

FIGS. 5 and 6 are flow charts showing an example of an auto channel preset operation performed by the television broadcast receiver 11 according to an embodiment of the invention. In FIGS. 5 and 6, the same steps as those in FIGS. 3 and 4 are denoted by the same reference numerals.

After step S18, described above, in step S28, the CPU 25 determines whether or not the sound carrier for the B/G, I, or D/K system is detected if the current demodulation mode corresponds to the positive modulation mode. On the other hand, the CPU 25 determines whether or not the sound carrier for the L system is detected if the current demodulation mode corresponds to the negative modulation mode.

In step S28, if the sound carrier for the B/G, I, D/K, or L system is detected (YES), the CPU 25 determines that the current demodulation mode does not correspond to the television signal modulation mode. In step S29, the CPU 25 switches the demodulation mode and then shifts to step S21.

Further, in step S26, described above, if the reception channel CH has not exceeded its maximum value max (NO), the CPU 25 returns to step S15.

According to the example of operation shown in FIGS. 5 and 6, even if the search for broadcast channels is started in the mode in which television signals subjected to a positive modulation process are demodulated and the mode is then switched, during this operation, to the one in which television signals subjected to a negative modulation process are demodulated, then for the next reception channel, the broadcast channel detection operation is started again in the demodulation mode corresponding to the negative modulation mode.

That is, in the demodulation mode corresponding to one of the modulation modes, if the AFT signal is detected but the synchronization signal is not and the sound carrier causes it to be determined that the other modulation mode is used, then the demodulation mode is immediately switched to the one corresponding to the other modulation mode. Thus, if there are continuous broadcast channels based on the same modulation mode, the time required for auto channel preset is effectively reduced.

In the description of the above embodiment, the present invention is applied to the television broadcast receiver 11. However, the present invention is not limited to this aspect but is applicable to, for example, a DVD (Digital Versatile Disk) recording and reproduction apparatus.

FIG. 7 is a view showing a DVD recording and reproduction apparatus 30 according to another embodiment of the present invention.

The DVD recording and reproduction apparatus 30 has a function for receiving television signals to record picture or sound information or the like from the signals on the DVD or reading and externally outputting the picture or sound information from the DVD.

The DVD recording and reproduction apparatus 30 comprises a housing 31 formed like a thin box and having a front surface portion 32 on which a DVD installation section 33 and an operation section 34 composed of a power switch and various keys are arranged.

Further, the DVD recording and reproduction apparatus 30 receives operation information not only from the operation section 34 but also from a wireless remote controller 35 to control its own operations.

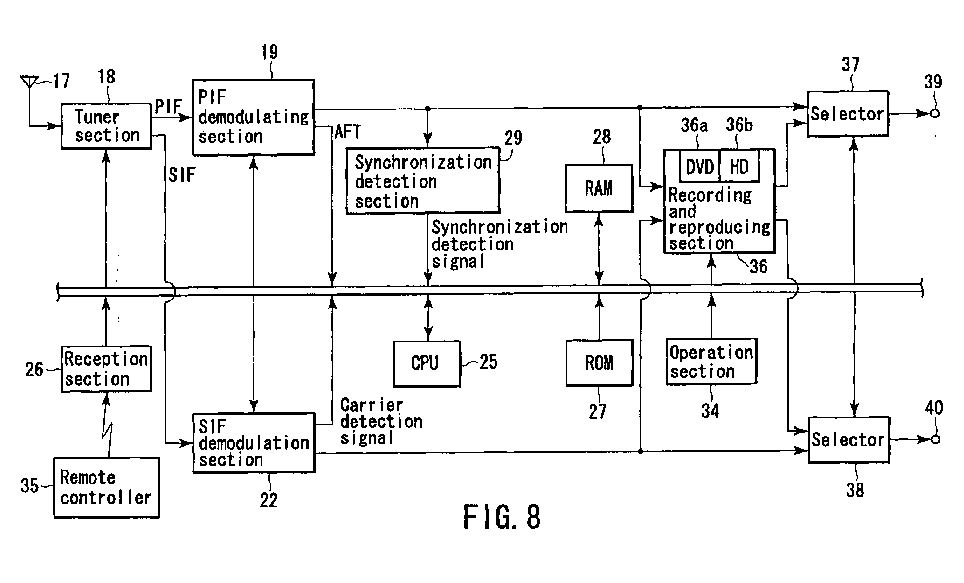

FIG. 8 is a block diagram showing a signal processing system of the DVD recording and reproduction apparatus 30 according to this embodiment. In FIG. 8, the same elements as those in FIG. 2 are denoted by the same reference numerals.

A picture signal outputted by the PIF demodulation section 19 is supplied to a recording and reproduction section 36 and to one of the input ends of a selector 37. Further, a sound signal outputted by the SIF demodulation section 22 is supplied to the recording and reproduction section 36 and to one of the input ends of a selector 38.

The recording and reproduction section 36 has a function of selectively recording the inputted picture and sound signals on one or both of a DVD 36a and a built-in hard disk 36b.

Further, the recording and reproduction section 36 reads picture and sound signals from the DVD 36a or the hard disk 36b, the read signals are output to the other input terminal of selector 37, 38.

Further, the recording and reproduction section 36 reads a picture and sound signals from the DVD 36a to record these signals on the hard disk 36b or reads a picture and sound signal from the hard disk 36b to record these signals on the DVD 36a.

In this case, the selector 37 functions to selectively guide picture signals outputted by the PIF demodulation section 19 and the recording and reproduction section 36, respectively, to an external output terminal 39.

Further, the selector 38 functions to selectively guide sound signals outputted by the SIF demodulation section 22 and the recording and reproduction section 36, respectively, to an external output terminal 40.

However, in FIG. 8, the recording and reproduction section 36 is not limited to the one having a function of recording and reproducing data on and from both DVD 36a and hard disk 36b. For example, the recording and reproduction section 36 may have a function of recording and reproduction data on and from either the DVD 36a or the hard disk 36b. Further, the storage medium is not limited to a DVD or hard disk, and other media can be used.

As described above, the broadcast receiving apparatus according to the present invention selects a predetermined one of a plurality of reception channels in accordance with a request for channel preset, and executes a process of detecting a first broadcast signal modulated by a first modulation mode, in a signal received through the selected reception channel. Then, if the first broadcast signal is detected, this reception channel is preset. On the other hand, if the first broadcast signal is not detected, the apparatus executes a process of detecting a second broadcast signal modulated by a second modulation mode, in the signal received through the selected reception channel. If the second broadcast signal is detected, this reception channel is preset. Then, if the reception channel is preset or the second broadcast signal is not detected, the next reception channel is selected. Then, a preset process is executed.

With the above configuration, a plurality of reception channels are sequentially switched, and a process of detecting the second broadcast signal based on the second modulation mode is executed only if the first broadcast signal based on the first modulation mode is not detected. Accordingly, the present apparatus can be sharply reduced in a processing time in comparison with the broadcast receiving apparatus present the conventional apparatus that executes a process of detecting the broadcast signals based on both modes, on all the reception channels.

In the broadcast receiving apparatus of the above embodiment, the PIF demodulation section 19 demodulates a television signal using the positive modulation mode from the receiving signal of the reception channel selected by the tuner section 18. If the television signal using the positive modulation mode is obtained by PIF demodulation section 19, the reception channel is registered in the RAM 28. On the other hand, if the television signal using the positive modulation mode is not obtained by PIF demodulation section 19, the SIF demodulation section 22 demodulates a television signal using the negative modulation mode from the receiving signal. If the television signal using the negative mode is obtained by SIF demodulation section 22, the reception channel is registered in the RAM 28.

The present invention is further characterized by providing a demodulation apparatus comprising a first demodulation mode in which a first of a plurality of broadcast signals which corresponds to the first modulation mode is demodulated and a second demodulation mode in which a second broadcast signal corresponding to the second modulation mode is demodulated, and the first or second demodulation mode is selected for the demodulation apparatus on the basis of the results of a preset process. In this case, the present invention is further characterized by providing a recording and reproduction apparatus that records and reproduces information contained in a demodulation signal from the demodulation apparatus.

The configuration described below is provided if the first broadcast signal is a television signal including a first picture signal modulated by the first modulation mode and a first sound signal contained in a sound carrier of a first frequency and if the second broadcast signal is a television signal including a second picture signal modulated by the second modulation mode and a second sound signal contained in a sound carrier of a second frequency.

A process of detecting the first broadcast signal demodulates a first picture signal from a signal received through a reception channel, on the basis of the first modulation mode, and if the first picture signal has been demodulated, generates a channel search signal. Then, if the channel search signal has been generated, the process detects a synchronization signal in the first picture signal. In this case, the preset process determines whether or not the first broadcast signal is detected under the condition that the synchronization signal is detected. Further, a process for detecting the second broadcast signal attempts to detect the sound carrier of the second frequency in a signal received through the reception channel if the channel search signal is generated but the synchronization signal of the first picture signal is not detected. Then, if the sound carrier is detected, the process demodulates a second picture signal from the signal received through the reception channel, on the basis of the second modulation mode. Also in this case, the preset process determines whether or not the second broadcast signal is detected under the condition that the synchronization signal is detected.

With the arrangement of the above embodiment, the channel search signal is the AFT (Automatic Fine Tuning) signal, and the first and second modulation modes are the positive and negative modulation processes.

## Claims

1. A method for automatically searching for and presetting a number of broadcast reception channels comprising:
setting a demodulation mode for either positive or negative modulated signals;
and setting one of the broadcast reception channels as a current reception channel;
wherein the method comprises the steps of searching the current reception channel for detecting an automatic fine tuning signal;
if no automatic fine tuning signal is detected, setting another reception channel as current reception channel and starting again with the search for a fine tuning signal, else searching a synchronizing signal;
if a synchronizing signal is detected, storing the current reception channel, setting another reception channel as current reception channel and starting again with the search for a fine tuning signal, else searching for a carrier detection signal for determining whether or not a sound carrier for one of a plurality of different broadcast standards is detected;
if it is determined that no sound carrier for any of the plurality of different broadcast standards is detected, setting another reception channel as current reception channel and starting again with the search for a fine tuning signal, else switching the demodulation mode from either positive to negative or vice versa, and searching again for a synchronization signal;
if a synchronizing signal is detected, storing the current reception channel, setting another reception channel as current reception channel and starting again with the search for a fine tuning signal, else setting another reception channel as current reception channel and starting again with the search for a fine tuning signal.

2. A broadcast receiving apparatus comprising
a CPU (25) adapted to perform the method of claim 1;
a tuner section (18) for receiving a television signal with a local oscillation signal for generating a picture intermediate frequency signal and an sound intermediate frequency signal;
a PIF demodulation section (19) for receiving a intermediate picture signal, for detecting a synchronizing signal, and for outputting the synchronizing signal to the CPU (25);
a SIF demodulation section (22) for receiving the sound intermediate frequency signal, for detecting a carrier detection signal and for outputting the carrier detection signal to the CPU (25); and
a RAM (28) for storing the reception channels.

3. A computer program, that when loaded in the internal memory (27) of a broadcast receiving apparatus according to claim 2 will cause the apparatus to perform the steps of the method of claim 1.

## Patentansprüche

1. Verfahren zum automatischen Suchen nach und Voreinstellen einer Anzahl von Rundfunkempfangskanälen, mit:
Einstellen eines Demodulationsmodus für entweder positiv- oder negativ- modulierte Signale,
und Einstellen eines der Rundfunkempfangskanäle als ein aktueller Empfangskanal;
wobei das Verfahren die Schritte eines Suchens des aktuellen Empfangskanals zum Erfassen eines automatischen Feinabstimmungssignals umfasst;
wenn kein automatisches Feinabstimmungssignal erfasst wird, Einstellen eines weiteren Empfangskanals als aktuellen Empfangskanal und erneutes Starten der Suche nach einem Feinabstimmungssignal, anderenfalls Suchen nach einem Synchronisationssignal; wenn ein Synchronisationssignal erfasst wird, Speichern des aktuellen Empfangskanals, Einstellen eines weiteren Empfangskanals als aktuellen Empfangskanal und erneutes Starten der Suche nach einem Feinabstimmungskanal, anderenfalls Suchen nach einem Trägererfassungssignal zum Bestimmen, ob ein Tonträger für einen einer Mehrzahl von unterschiedlichen Rundfunkstandards erfasst wird;
wenn bestimmt wird, dass kein Tonträger für einen der Mehrzahl von unterschiedlichen Rundfunkstandards erfasst wird, Einstellen eines anderen Empfangskanals als aktuellen Empfangskanal und erneutes Starten mit der Suche nach einem Feinabstimmungssignal, anderenfalls Umschalten des Demodulationsmodus entweder von positiv auf negativ oder umgekehrt, und erneutes Suchen nach einem Synchronisationssignal;
wenn ein Synchronisationssignal erfasst wird, Speichern des aktuellen Empfangskanals, Einstellen eines weiteren Empfangskanals als aktuellen Empfangskanal und erneutes Starten mit der Suche nach einem Feinabstimmungssignal, anderenfalls Einstellen eines weiteren Empfangskanals als aktuellen Empfangskanal und erneutes Starten mit der Suche nach einem Feinabstimmungssignal.

2. Rundfunkempfangsvorrichtung, mit
einer CPU (25), die angepasst ist, um das Verfahren gemäß Anspruch 1 durchzuführen;
einem Tunerabschnitt (18) zum Empfangen eines Fernsehsignals mit einem lokalen Schwingungssignal zum Erzeugen eines Bild-Zwischensignals und eines Ton-Zwischensignals;
einem PIF-Demodulationsabschnitt (19) zum Empfangen des Zwischenbildsignals, zum Erfassen eines Synchronisationssignals und zum Ausgeben des Synchronisationssignals an die CPU (25);
einem SIF-Demodulationsabschnitt (22) zum Empfangen des Ton-Zwischensignals, zum Erfassen eines Trägererfassungssignals und zum Ausgeben des Trägererfassungssignals an die CPU (25); und
einem RAM (28) zum Speichern der Empfangskanäle.

3. Computerprogramm, dass, wenn es in den internen Speicher (27) einer Rundfunkempfangsvorrichtung gemäß Anspruch 2 geladen ist, die Vorrichtung veranlassen wird, die Schritte des Verfahrens von Anspruch 1 auszuführen.

## Revendications

1. Procédé pour rechercher automatiquement et prérégler un nombre de canaux de réception de télédiffusion comportant:
la détermination d'un mode de démodulation pour des signaux modulés soit positifs soit négatifs ;
et la détermination de l'un des canaux de réception de télédiffusion en tant que canal de réception courant ;
dans lequel le procédé comporte les étapes de recherche du canal de réception courant pour détecter un signal d'accord fin automatique ;
si aucun signal d'accord fin automatique n'est détecté, déterminer un autre canal de réception en tant que canal de réception courant et recommencer la recherche pour un signal d'accord fin, sinon rechercher un signal de synchronisation ;
si un signal de synchronisation est détecté, mémoriser le canal de réception courant, déterminer un autre canal de réception en tant que canal de réception courant et redémarrer la recherche d'un signal d'accord fin, sinon rechercher un signal de détection de porteuse pour déterminer si oui ou non une porteuse de son pour l'un d'une pluralité de différents standards de diffusion est détectée;
s'il est déterminé qu'aucune porteuse de son pour l'un quelconque de la pluralité de standards de diffusion différents n'est détectée, déterminer un autre canal de réception en tant que canal de réception courant et recommencer la recherche pour un signal d'accord fin, sinon commuter le mode de démodulation à partir de l'un soit positif soit négatif ou vice versa, et rechercher un signal de synchronisation ;
si un signal de synchronisation est détecté, mémoriser le canal de réception courant, déterminer un autre canal de réception en tant que canal de réception courant et redémarrer la recherche pour un signal d'accord fin, sinon déterminer un autre canal de réception en tant que canal de réception courant et redémarrer la recherche pour un signal d'accord fin.

2. Appareil de réception de télédiffusion comportant:
une CPU (25) adaptée pour exécuter le procédé de la revendication 1 ;
une section de tuner (18) pour recevoir un signal de télévision avec un signal d'oscillation locale pour générer un signal de fréquence intermédiaire d'image et un signal de fréquence intermédiaire de son ;
une section de démodulation PIF (19) pour recevoir un signal d'image intermédiaire, pour détecter un signal de synchronisation, et pour délivrer le signal de synchronisation à la CPU (25) ;
une section de démodulation SIF (22) pour recevoir le signal de fréquence intermédiaire de son, pour détecter un signal de détection de porteuse et pour délivrer le signal de détection de porteuse à la CPU (25) ; et
une RAM (28) pour mémoriser les canaux de réception.

3. Programme informatique, qui, lorsqu'il est chargé dans la mémoire interne (27) d'un appareil de réception de télédiffusion selon la revendication 2, amène l'appareil à effectuer les étapes du procédé de la revendication 1.
